# EUROPEAN PATENT APPLICATION

(11) **EP 4 088 972 A1**
(43) Date of publication of application: **16.11.2022**
(21) Application number: 22165504.6
(22) Date of filing: 30.03.2022
(51) Int. Cl.: B60Q 3/54, B60Q 3/74, B32B 7/12, F21K 9/00, F21V 19/00, G09F 9/302, G09F 9/33, G09F 13/04, G09G 3/32, H01L 25/00, H01L 25/075, H01L 27/15, H05K 1/18, F21Y 105/10, F21Y 115/10

(54) **VEHICLE LIGHTING DEVICE**

(30) Priority: 10.05.2021 KR 20210060268; 23.03.2022 KR 20220036022
(71) Applicant: AIT Co., Ltd., Incheon 22770 (KR)
(72) Inventor: RHEE, Geon Hwan, 15039 Gyeonggi-do (KR)
(74) Representative: SONN Patentanwälte OG

(57) **Abstract**

A vehicle lighting device is disclosed. The vehicle lighting device according to one aspect of the present invention, which is a vehicle lighting device irradiating an interior space of a vehicle with light, includes: a light emitting module configured to irradiate the interior space with light transmitted through an inner layer surrounding the interior space; an optical module disposed between the light emitting module and the inner layer so that the light radiated from the light emitting module is transmitted therethrough; and a transmission module which is disposed between the optical module and the inner layer and includes one portion through which the light emitted from the light emitting module is transmitted and another portion configured to block the emitted light, wherein the light emitting module includes a light emitting diode (LED) member electrically conducted to the outside to emit the light according to a control signal and an applied voltage transmitted thereto, the optical module includes an optical body which is formed of a light-permeable material and disposed to cover the inner layer and an optical hole which is formed to be recessed in or penetrate through the inside of the optical body to form a space in a thickness direction thereof, and the LED member includes a first LED member which is accommodated in the optical hole and configured to irradiate the inner layer with light and a second LED member which is disposed on an edge surface of the optical body and configured to irradiate the inner layer with light transmitted through the inside of the optical body.

## Description

### CROSS-REFERENCE TO RELATED APPLICATION

This application claims priority to and the benefit of Korean Patent Application No. 2021-0060268, filed on May 10, 2021 and Korean Patent Application No. 2022-0036022, filed on March 23, 2022, the disclosure of which is incorporated herein by reference in its entirety.

### BACKGROUND

### 1. Field of the Invention

The present invention relates to a vehicle lighting device and a vehicle including the same, and more particularly, to a vehicle lighting device, which is capable of irradiating the inside of a vehicle with light and forming images of various forms while disposed in the vehicle, and a vehicle including the same.

### 2. Discussion of Related Art

In recent years, with improvements in standard of living and the increase in the importance of leisure activities, the number of people traveling away from their main living spaces has increased. For a more convenient and enjoyable trip, people tend to use private vehicles rather than public transportation.

In addition, as is well known through mass media and the like, so-called "auto-camping," in which people stay inside a vehicle instead of staying in a traditional type of accommodation, has gained sensational popularity. That is, the time people spend in the spaces inside vehicles has increased as compared to the past, and demands regarding the environment inside the vehicle, i.e., the interior, have also increased.

Accordingly, vehicle manufacturers have made various attempts to transform the space inside a vehicle into a space where people can feel comfort and enjoyment, not just a space to stay while moving.

Examples of these various attempts include improving the interior lighting with a mood lamp. In the past, generally, a room lamp or the like was used to irradiate an interior space with light to allow objects to be identified or simple tasks to be performed. However, in recent years, with the increase in the time people spend in interior spaces of vehicles as described above, demands for lighting have also diversified.

However, it is not easy to provide various types of lighting inside a vehicle. Vehicles are subject to many restrictions on their physical and electrical structure due to safety issues. For example, the interior space of a vehicle should be surrounded by a soft protective material to prevent injury to occupants in the event of a collision.

Further, in order to form various types of lighting in the interior space of a vehicle, various devices such as a large number of lamps and a wiring structure, a power source, etc. for supplying power to the lamps are required. Due to these limitations, it is difficult to secure diversity in interior lighting provided in a vehicle.

Accordingly, techniques for addressing the above problems have been introduced.

Korean Patent Registration No. 10-1684122 discloses a headlining hidden lighting device. Specifically, it discloses a lighting device which is installed on the headlining of the interior of a vehicle to implement lighting that is not visible from the outside by a lighting source being inserted between the headlining fabric and a base material.

However, the headlining hidden lighting device disclosed in the above related art document has a limitation that it occupies an excessive amount of space. That is, the headlining hidden lighting device disclosed in the above related art document has a structure in which a printed circuit board (PCB) for its control is also mounted on the headlining, and there is concern that the thickness of the headlining may be increased. Accordingly, when an occupant is tall, the occupant may feel discomfort due to the occupant's head coming into contact with the headlining.

Even when the PCB is accommodated while the height of the headlining is maintained, there is still concern that the headlining hidden lighting device may occupy an excessive amount of space between the upper side of the headlining and an outer frame.

In addition, because a polyimide film material for typical flexible printed circuit boards (FPCBs) having flexibility that is disclosed in the above related art document includes a conductive thin film, a manufacturing process for configuring a circuit pattern is difficult and complicated, and heat forming is difficult, which makes it difficult to maintain and implement various designs and the shapes of corners with small curvatures.

Korean Patent Registration No. 10-1519757 discloses a vehicle mood lamp and a lighting method using the same. Specifically, it discloses a vehicle mood lamp in which an electroluminescent sheet is inserted into the skin of a headlining that surrounds an interior space to implement mood lighting in the interior of the vehicle, and a lighting method using the same.

However, it is difficult to implement various designs using the vehicle mood lamp and lighting method using the same disclosed in the above related art document. That is, although the vehicle mood lamp disclosed in the above related art document is able to change its color, no method of changing an image formed by light without changing the shape of polyurethane foam supporting a light source is proposed.

### [Related Art Documents]

### [Patent Documents]

(Patent Document 0001) Korean Patent Registration No. 10-1684122 (Date of Registration: December 8, 2016)
(Patent Document 0002) Korean Patent Registration No. 10-1519757 (Date of Registration: May 12, 2015)

### SUMMARY OF THE INVENTION

The present invention is directed to providing a vehicle lighting device which has a structure that can be effectively applied according to the shape of a vehicle, and a vehicle including the same.

The present invention is also directed to providing a vehicle lighting device which has a structure capable of effectively forming images of various forms, and a vehicle including the same.

The present invention is also directed to providing a vehicle lighting device which has a structure capable of forming images of various forms in a space inside a vehicle, and a vehicle including the same.

The present invention is also directed to providing a vehicle lighting device which has a structure capable of preventing damage to a component for emitting light, and a vehicle including the same.

The present invention is also directed to providing a vehicle lighting device which has a structure with an aesthetically pleasing exterior, and a vehicle including the same.

Objectives of the present invention are not limited to those mentioned above, and other unmentioned objectives should be clearly understood by those of ordinary skill in the art to which the present invention pertains from the description below.

One aspect of the present invention provides a vehicle lighting device irradiating an interior space of a vehicle with light, the vehicle lighting device including: a light emitting module configured to irradiate the interior space with light transmitted through an inner layer surrounding the interior space; an optical module disposed between the light emitting module and the inner layer so that the light radiated from the light emitting module is transmitted therethrough; and a transmission module which is disposed between the optical module and the inner layer and includes one portion through which the light emitted from the light emitting module is transmitted and another portion configured to block the emitted light, wherein the light emitting module includes a light emitting diode (LED) member electrically conducted to the outside to emit the light according to a control signal and an applied voltage transmitted thereto, the optical module includes an optical body which is formed of a light-permeable material and disposed to cover the inner layer and an optical hole which is formed to be recessed in or penetrate through the inside of the optical body to form a space in a thickness direction thereof, and the LED member includes a first LED member which is accommodated in the optical hole and configured to irradiate the inner layer with light and a second LED member which is disposed on an edge surface of the optical body and configured to irradiate the inner layer with light transmitted through the inside of the optical body.

Here, a portion of the light emitted from the LED member may be transmitted due to the one portion of the transmission module and another portion of the light emitted from the LED member may be blocked by the other portion of the transmission module, thus creating a mood lighting atmosphere.

Also, the optical hole may, in a thickness direction of the optical module, accommodate the first LED member or a circuit element member electrically conducted to the first LED member.

Here, the circuit element member may be provided as a plurality of circuit element members, and the plurality of circuit element members may be configured to control the LED member according to the applied voltage and the control signal transmitted thereto.

Also, the optical hole may be provided as a plurality of optical holes, and the plurality of optical holes may be disposed to be spaced apart from each other in a width direction of the optical body.

Here, the second LED member may be provided as a plurality of second LED members, and the plurality of second LED members may each be disposed on one edge surface of the optical body.

The optical module may include a refractive member which is inserted into the optical hole and includes an optic part configured to refract the light radiated from the first LED member accommodated in the optical hole.

Here, the optical body may be formed of a soft material or a hard material to accommodate any one or more of the LED member, the circuit element member electrically conducted to the LED member, and the optic part and prevent protrusion thereof in the thickness direction.

Also, an optic part configured to refract the light radiated from the first LED member accommodated in the optical hole may be formed at one side surface of the optical body that faces the inner layer.

Here, the optic part may be provided as a plurality of optic parts, and the plurality of optic parts may be formed to have different shapes.

Also, the optic part may be provided as a plurality of optic parts, and the plurality of optic parts may be disposed to correspond to the optical hole which is provided as a single optical hole or a plurality of optical holes.

Here, the light emitting module may be modularized and provided as a plurality of light emitting modules, and the plurality of light emitting modules may be disposed to correspond to the shape of the inner layer.

Also, the optical module may be modularized and provided as a plurality of optical modules, and the plurality of optical modules may be disposed to correspond to the plurality of light emitting modules.

Here, the first LED member and the second LED member may be provided as any one or more of an LED, a mini LED, a micro LED, and an LED ink, and the light radiated from the first LED member or the second LED member may have a single color, red, green, and blue (RGB), or a combination thereof.

Also, rays of light radiated from the first LED member and the second LED member may at least partially overlap on the inner layer or in the interior space to form a predetermined image.

Also, rays of light independently radiated from the second LED member may at least partially overlap on the inner layer or in the interior space to form a predetermined image.

Here, the LED member may be provided as a plurality of LED members, the plurality of LED members may be disposed in different regions, any one or more of emission of light, and the direction, luminous intensity, illumination, luminance, and color of the emitted light may be independently controlled for the plurality of LED members, and the light emitted from the plurality of LED members may form an image of a character, a figure, a picture, a motion, or a combination thereof.

Also, the optical module may include a plurality of optic parts configured to refract the light radiated from the plurality of LED members each inserted into one of the plurality of optical holes, and the plurality of optic parts may be formed to have different shapes so that the light radiated from the plurality of LED members transmit through the plurality of optic parts and from images of different shapes.

Here, the light emitted from the LED member may sequentially pass through the one portion of the transmission module and the inner layer to form a predetermined image in the interior space.

Also, the one portion of the transmission module may be formed of a character, a figure, a picture, a motion, or a combination thereof.

Also, one aspect of the present invention provides a vehicle including: an inner layer surrounding an interior space; and a vehicle lighting device stacked on the inner layer to irradiate the interior space with light, wherein the vehicle lighting device includes a light emitting module which is configured to irradiate the interior space with light transmitted through the inner layer and an optical module which is disposed between the light emitting module and the inner layer so that the light radiated from the light emitting module is transmitted therethrough, the light emitting module includes a first LED member which is configured to irradiate the inner layer with light vertical thereto and a second LED member which is configured to irradiate the inner layer with light horizontal thereto, the optical module includes an optical body which is formed of a light-permeable material and disposed to cover the inner layer and a plurality of optical holes which are formed to penetrate or not penetrate through the inside the optical body in a thickness direction thereof, the first LED member is accommodated in the optical hole and configured to irradiate the inner layer with light, and the second LED member is disposed on an edge surface of the optical body and configured to irradiate the inner layer with light transmitted through the inside of the optical body.

Here, the optical module may include a plurality of optic parts accommodated in the plurality of optical holes and configured to refract the light radiated from the LED member, and any one or more of the plurality of optic parts may be formed to have a shape different from that of one or more other optic parts.

Also, the vehicle lighting device may further include a transmission module which is disposed between the optical module and the inner layer and includes one portion through which the light emitted from the LED member is transmitted and another portion configured to block the emitted light.

Here, the first LED member may be provided as a plurality of first LED members and the plurality of first LED members may each be accommodated in one of the plurality of optical holes, and the second LED member may be provided as a plurality of second LED members and the plurality of second LED members may each be disposed on one edge surface of the optical body.

Also, the light irradiated by the first LED member and the light irradiated by the second LED member may at least partially overlap on the inner layer or in the interior space to form a predetermined image.

### BRIEF DESCRIPTION OF THE DRAWINGS

The above and other objects, features and advantages of the present invention will become more apparent to those of ordinary skill in the art by describing exemplary embodiments thereof in detail with reference to the accompanying drawings, in which:
FIG 1 shows a lateral cross-sectional view and an enlarged view of a vehicle including a vehicle lighting device according to an embodiment of the present invention;
FIG 2 is an exploded perspective view illustrating a configuration of the vehicle lighting device of FIG 1;
FIG. 3 is a cross-sectional view illustrating the configuration of the vehicle lighting device of FIG. 1;
FIG. 4 is a conceptual diagram illustrating a light emitting module of the vehicle lighting device according to an embodiment of the present invention;
FIG. 5 is a block diagram illustrating a configuration of the light emitting module of the vehicle lighting device according to an embodiment of the present invention;
FIG. 6 is a plan view illustrating a transmission module according to an embodiment of the present invention;
FIG. 7 is a cross-sectional view illustrating light emitted from the vehicle lighting device of FIG. 1; and
FIGS. 8 to 12 are conceptual diagrams illustrating operation states of the vehicle lighting device according to an embodiment of the present invention.

### DETAILED DESCRIPTION OF EXEMPLARY EMBODIMENTS

Hereinafter, embodiments of the present invention will be described in detail with reference to the accompanying drawings to allow those of ordinary skill in the art to which the present invention pertains to easily practice the present invention. The present invention may be implemented in various different forms and is not limited to the embodiments described herein. In order to clearly describe the present invention, parts unrelated to the description have been omitted from the drawings, and the same or similar elements will be denoted by the same reference numerals throughout the specification.

Terms used in this specification and the claims should be construed as having meanings and concepts that are consistent with the technical spirit of the present invention according to the principle that the inventor may define terms and concepts to describe his or her invention in the best way, rather than being construed as having general or dictionary meanings and being limited thereto.

Therefore, embodiments described in this specification and configurations illustrated in the drawings correspond to exemplary embodiments of the present invention and do not represent the entire technical spirit of the present invention. Thus, various equivalents and modifications that may replace the corresponding configurations may be present at the time of filing of this application.

In the following description, descriptions of some components may be omitted to clarify features of the present invention.

The term "electrically conducted" used in the following description refers to a state in which one or more members are connected to be able to transmit and receive electricity or electronic signals to and from each other. In one embodiment, electrical conduction may be implemented in a wired form using a lead wire member or the like or implemented in a wireless form using Bluetooth, Wi-Fi, RFID, etc.

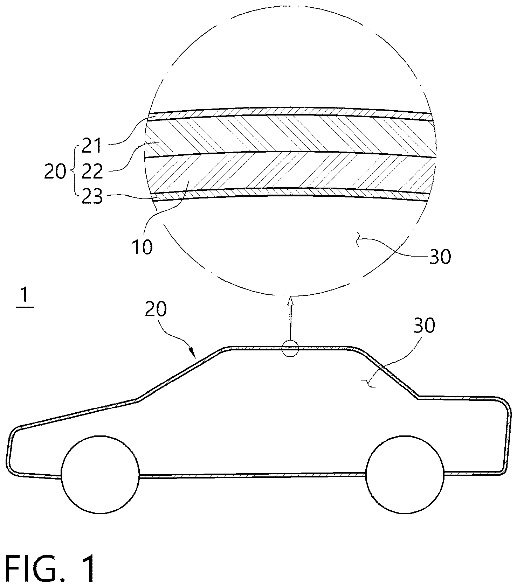

Referring to FIG. 1, a state in which a vehicle lighting device 10 according to an embodiment of the present invention is disposed in a vehicle 1 is illustrated as an example. The vehicle lighting device 10 may be mounted inside a frame 20 that constitutes an exterior of the vehicle 1.

Specifically, the frame 20 is formed to surround an interior space 30, i.e., a space configured to accommodate an occupant or an object, that is formed inside the vehicle 1. In other words, the interior space 30 is a space formed to be surrounded by the frame 20.

Here, the vehicle lighting device 10 according to an embodiment of the present invention is configured to be accommodated inside the frame 20 to irradiate the interior space 30 with light L. To this end, the vehicle lighting device 10 may be coupled to the frame 20, and the light L radiated from the vehicle lighting device 10 may pass through some layers of the frame 20 and extend into the interior space 30.

The frame 20 may be formed in any shape that allows the frame 20 to form the exterior of the vehicle 1, surround the interior space 30, and protect an occupant or an object accommodated in the interior space 30. In the illustrated embodiment, the frame 20 includes an outer layer 21, a mold layer 22, and an inner layer 23.

The outer layer 21 forms an outer surface of the frame 20. The outer layer 21 is a portion where the frame 20 is exposed at the outside of the vehicle 1. As is known, the outer layer 21 may be formed of a rigid body and protect the interior space 30 from impact applied from the outside.

The mold layer 22 forms an intermediate portion of the frame 20. The mold layer 22 is coupled to each of the outer layer 21 and the inner layer 23.

The inner layer 23 forms an inner surface of the frame 20. The inner layer 23 surrounds the interior space 30. In other words, the inner layer 23 is a portion that is exposed in the interior space 30 and comes in direct contact with the occupant or object accommodated in the interior space 30.

Therefore, in order to increase comfort of the occupant accommodated in the interior space 30, the inner layer 23 may be formed of a fabric material or any other known interior materials. In one embodiment, the inner layer 23 may be formed of a leather material.

In particular, the inner layer 23 according to an embodiment of the present invention may be formed of a light-permeable material. The light L emitted from the vehicle lighting device 10 may pass through the inner layer 23 and extend into the interior space 30.

The inner layer 23 may be formed in a shape that corresponds to the shape of the outer layer 21. That is, with regards to an exterior of a typical vehicle 1, the outer layer 21 is formed to include both a flat surface and a curved surface. Thus, the inner layer 23 may also be formed to include both a flat surface and a curved surface in order to correspond to the shape of the outer layer 21. This may be achieved by characteristics of the above-mentioned materials of the inner layer 23.

The vehicle lighting device 10 according to an embodiment of the present invention may be configured to be coupled to the mold layer 22 and radiate the light L toward the inner layer 23. That is, the vehicle lighting device 10 is disposed between the mold layer 22 and the inner layer 23.

Therefore, with regards to the cross-section of the vehicle 1, the inner layer 23, the vehicle lighting device 10, the mold layer 22, and the outer layer 21 are sequentially stacked in that order in a direction from the interior space 30 toward the outside.

The frame 20 may be any point forming the exterior and interior of the vehicle 1. In the illustrated embodiment, the frame 20 is a ceiling portion, i.e., a headlining portion, that is disposed at an upper side of the vehicle 1.

As an alternative, the frame 20 may be any point at least partially surrounding the interior space 30 of the vehicle 1 that includes a trim, a dashboard, a pillar, a rear portion, a front portion, and the like disposed in the vehicle 1 to form an inner side thereof.

That is, the vehicle lighting device 10 according to an embodiment of the present invention is not limited to being disposed at the ceiling portion of the vehicle 1 but may be disposed at any point of the vehicle 1, such as a sun visor, a sunroof cover, an assist handle, a door trim, a dashboard, a garnish, a center console, a console box, a seat, a door scuff, a car seat, or a car mat to irradiate the interior space 30 with the light L.

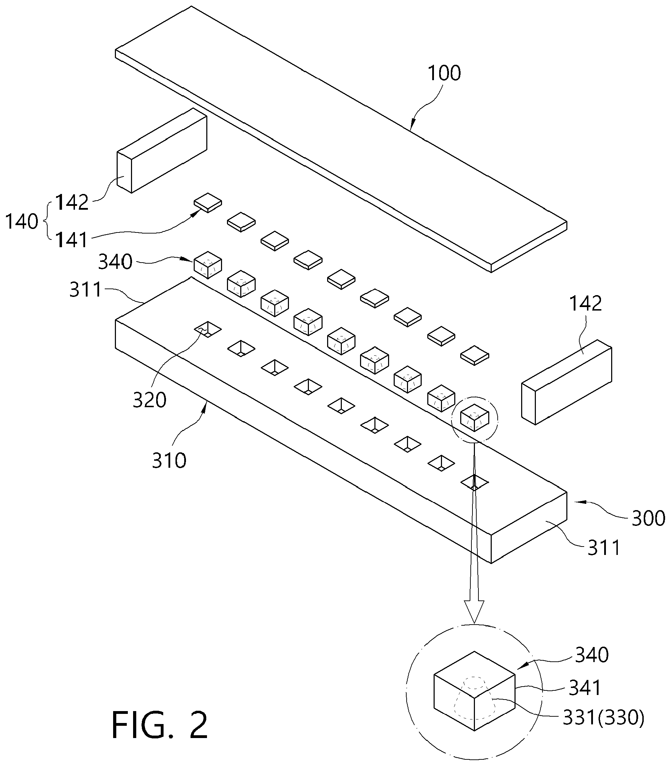

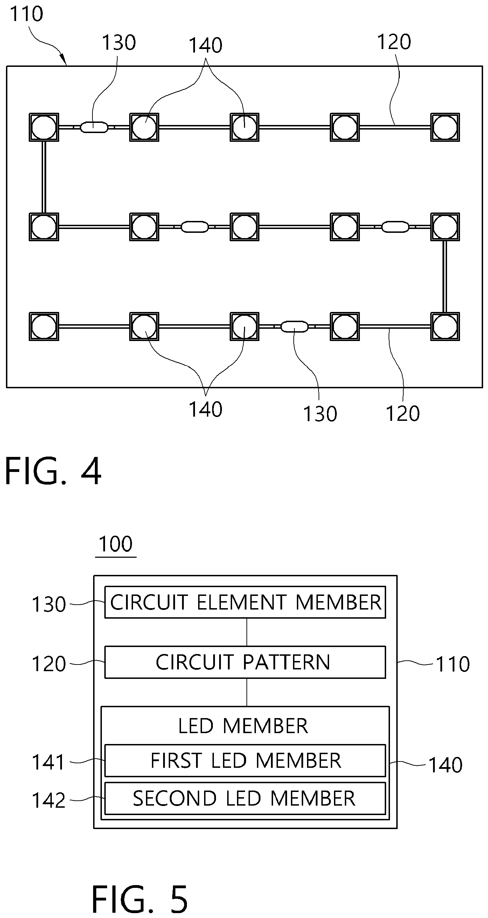

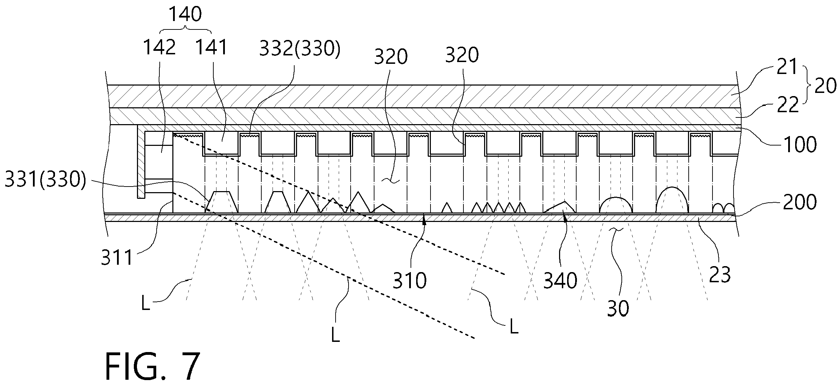

Hereinafter, a configuration of the vehicle lighting device 10 according to an embodiment of the present invention will be described in detail with reference to FIGS. 2 to 7.

The vehicle lighting device 10 according to an embodiment of the present invention may be disposed inside the frame 20, specifically, between the mold layer 22 and the inner layer 23, to radiate the light L that passes through the inner layer 23. The light L radiated by the vehicle lighting device 10 may extend into the interior space 30 and form images of various forms.

As will be described below, the light L radiated by the vehicle lighting device 10 according to an embodiment of the present invention may form an image of a character, a figure, a picture, a motion, or a combination thereof.

The formed image may be formed on the inner layer 23 of the frame 20 and visually recognized by the occupant accommodated in the interior space 30. Accordingly, comfort and an emotional sense of stability of the occupant accommodated in the interior space 30 may be improved. This will be described in detail below.

In particular, the vehicle lighting device 10 according to an embodiment of the present invention may be formed to correspond to the above-described shape of the frame 20, i.e., the shape that includes both a flat surface and a curved surface. Therefore, the vehicle lighting device 10 may be stably coupled to the frame 20, and the volume of the interior space 30 that is occupied by the vehicle lighting device 10 may be reduced.

In one embodiment, the vehicle lighting device 10 may be formed in a shape which is the same as the shape of the inner layer 23 and disposed to cover the inner layer 23. In this embodiment, the vehicle lighting device 10 may be provided as a single member and disposed to be stacked on the inner layer 23.

In another embodiment, the vehicle lighting device 10 may have a shape corresponding to the inner layer 23 but have an area smaller than the area of the inner layer 23. In this embodiment, the vehicle lighting device 10 may be provided as a plurality of vehicle lighting devices 10, and the plurality of vehicle lighting devices 10 may be stacked to partially cover the inner layer 23. That is, in this embodiment, the vehicle lighting device 10 may be provided to be modular.

Therefore, it may be said that the vehicle lighting device 10 at least partially surrounds the inner layer 23 and the interior space 30 that is surrounded by the inner layer 23.

In the illustrated embodiment, the vehicle lighting device 10 includes a light emitting module 100, a transmission module 200, and an optical module 300.

Here, the transmission module 200 may be selectively included. In other words, the vehicle lighting device 10 may only include the light emitting module 100 and the optical module 300 or may further include the transmission module 200.

Therefore, it should be understood that application of various forms of modifications is possible according to conditions of the vehicle 1 in which the vehicle lighting device 10 is included.

The light emitting module 100 is a portion where the vehicle lighting device 10 is coupled to the mold layer 22. One surface of the light emitting module 100 that faces the mold layer 22, an upper surface of the light emitting module 100 in the illustrated embodiment, is coupled to a lower surface of the mold layer 22. In other words, the inner layer 23, the light emitting module 100, and the mold layer 22 are sequentially stacked in that order in the direction from the interior space 30 toward the outside.

Also, the light emitting module 100 is electrically conducted to the outside to receive an applied voltage and a control signal and emits the light L accordingly. As described above, an image is formed on the inner layer 23 or in the interior space 30 due to the emitted light L.

The light emitting module 100 may be formed in a shape that corresponds to the shape of the frame 20. As described above, the frame 20 is formed in the shape of a plate that includes both a flat surface and a curved surface. Accordingly, the light emitting module 100 may also be formed in the shape of a plate including both a flat surface and a curved surface and may be adhered and coupled to the frame 20.

The light emitting module 100 may constitute a body of the vehicle lighting device 10. The light emitting module 100 may be formed in a shape that corresponds to the shape of the mold layer 22 or the inner layer 23 which is coupled to the light emitting module 100.

As described above, in one embodiment, the vehicle lighting device 10 may be provided to have an area equal to the area of the mold layer 22 or the inner layer 23. In this embodiment, the light emitting module 100 may be formed to have an area equal to the area of the mold layer 22 or the inner layer 23. In this embodiment, a single light emitting module 100 may be disposed to surround the inner layer 23 and the interior space 30 surrounded by the inner layer 23.

Also, in another embodiment, the vehicle lighting device 10 may be provided to have an area smaller than the area of the mold layer 22 or the inner layer 23. In this embodiment, the light emitting module 100 may be formed to have an area smaller than the area of the mold layer 22 or the inner layer 23. In this embodiment, each of a plurality of light emitting modules 100 may be disposed to partially surround the inner layer 23 and the interior space 30 surrounded by the inner layer 23.

That is, in this embodiment, the light emitting module 100 may be modularized and provided as a plurality of light emitting modules 100, and the plurality of light emitting modules 100 may be disposed in a direction extending in the shape of the inner layer 23.

In an embodiment illustrated in FIGS. 2 to 4, the light emitting module 100 includes a substrate member 110, a circuit pattern 120, a circuit element member 130, and a light emitting diode (LED) member 140.

The substrate member 110 forms a body of the light emitting module 100. The substrate member 110 is a portion where the light emitting module 100 is coupled to the frame 20, specifically, the mold layer 22.

The circuit pattern 120 is formed on the substrate member 110. In one embodiment, the circuit pattern 120 may be printed on the substrate member 110 by any one or more of printing processes including a plate-making mask, stamping, dispensing, inkjet, laser, gravure, and a pad using a conductive paste.

That is, in this embodiment, the circuit pattern 120 may be formed on the substrate member 110 using a conductive material.

Here, a dielectric region formed using a dielectric material may be formed on the substrate member 110 or the circuit pattern 120.

That is, the dielectric region may be formed on the substrate member 110 or the circuit pattern 120 by any one or more of printing processes including a plate-making mask, stamping, dispensing, inkjet, laser, gravure, and a pad using a dielectric paste or dielectric adhesive.

Also, the circuit pattern 120 and the dielectric region formed on the substrate member 110 may be formed as a plurality of circuit patterns 120 and a plurality of dielectric regions. The plurality of circuit patterns 120 and the plurality of dielectric regions may be alternately stacked on the substrate member 110.

In one embodiment, the circuit element member 130 and the LED member 140 may be disposed on the plurality of circuit patterns 120 and the plurality of dielectric regions that are alternately stacked.

The plurality of circuit patterns 120, the circuit element member 130, and the LED member 140 which are formed on the substrate member 110 are coupled and electrically conducted.

In one embodiment, the circuit element member 130 and the LED member 140 may be applied onto the substrate member or the circuit pattern by any one or more of printing processes including a plate-making mask, stamping, dispensing, inkjet, gravure, and a pad using a conductive adhesive and may be coupled to the circuit pattern 120 formed on the substrate member 110 by a typical bonding process.

That is, in this embodiment, the circuit element member 130 and the LED member 140 may be coupled and electrically conducted to the circuit pattern 120 formed on the substrate member 110 using a conductive material.

As an alternative, in order to strengthen the adhesion of the circuit element member 130 and the LED member 140, an adhesive material may be used for coupling of the circuit element member 130 and the LED member 140 to the circuit pattern 120 formed on the substrate member 110.

That is, the circuit element member 130 and the LED member 140 may be applied onto the substrate member 110 or the circuit pattern 120 by any one or more of printing processes including a plate-making mask, stamping, dispensing, inkjet, laser, gravure, and a pad using an adhesive and may be coupled to the circuit pattern 120 formed on the substrate member 110 by a typical bonding process to increase element adhesion.

That is, in one embodiment, the circuit element member 130 and the LED member 140 may be applied onto the circuit pattern by any one or more of printing processes including a plate-making mask, stamping, dispensing, inkjet, laser, gravure, and a pad using an adhesive paste to constitute multiple circuit layers.

The substrate member 110 may be formed in the shape of a plate. The circuit pattern 120 may be formed on one surface of the substrate member 110 that faces the interior space 30, a lower surface of the substrate member 110 in the illustrated embodiment, and the circuit element member 130 is coupled and electrically conducted to the circuit pattern 120. The LED member 140 is coupled to the lower surface and electrically conducted to the circuit pattern 120 and the circuit element member 130.

The other surface of the substrate member 110 that is opposite to the interior space 30, an upper surface of the substrate member 110 in the illustrated embodiment, is coupled to the mold layer 22. In one embodiment, the other surface of the substrate member 110 may be fixed and coupled to the mold layer 22.

The substrate member 110 may be formed of a flexible material. Accordingly, the plate-shaped substrate member 110 may be deformed to correspond to the shape of the mold layer 22 or inner layer 23. Therefore, it should be understood that the substrate member 110 and the mold layer 22 may be adhered and coupled to each other.

In one embodiment, the substrate member 110 may be formed of any one or more of a synthetic resin film, leather, artificial leather, fabric, nonwoven fabric, foam, and felt.

The plate-shaped substrate member 110 may extend in an arbitrary direction. For example, in an embodiment in which the vehicle lighting device 10 is disposed at the ceiling portion of the vehicle 1, the plate-shaped substrate member 110 may extend in the left-right direction and front-rear direction to correspond to the ceiling portion. The shape of the substrate member 110 may be changed to correspond to the shape of the frame 20 coupled thereto.

In one embodiment, the plate-shaped substrate member 110 may be formed to have an area that corresponds to the area of the frame 20. In this embodiment, the light emitting module 100 may be provided as a single light emitting module 100, and a single substrate member 110 may be configured to cover the entire frame 20. Accordingly, the single substrate member 110 may be disposed to cover the entire inner layer 23.

In another embodiment, the plate-shaped substrate member 110 may be formed to have an area smaller than the area of the frame 20. In this embodiment, the substrate member 110 may be provided as a plurality of substrate members 110. Each of the plurality of substrate members 110 may be disposed to at least partially cover the inner layer 23. Accordingly, the plurality of substrate members 110 may be disposed to cover the inner layer 23 together.

That is, in this embodiment, it should be understood that the light emitting module 100 is provided to be modular. In this embodiment, the plurality of substrate members 110 may be disposed in any form that allows the plurality of substrate members 110 to cover the inner layer 23. In one embodiment, the substrate members 110 may be disposed to be parallel in the left-right direction and front-rear direction.

The circuit pattern 120 is configured to be electrically conducted to the outside to receive an applied voltage and a control signal. The received applied voltage and control signal are transmitted to the circuit element member 130 and the LED member 140 which are coupled and electrically conducted to the circuit pattern 120. The LED member 140 may be operated according to the received applied voltage and control signal and emit the light L in various forms.

The circuit pattern 120 is formed on the substrate member 110. As described above, the circuit pattern 120 is made of a conductive material and formed on the substrate member 110. In one embodiment, the circuit pattern 120 may be printed on the substrate member 110.

The circuit pattern 120 is coupled and electrically conducted to the circuit element member 130. The applied voltage and control signal transmitted to the circuit pattern 120 may be transmitted to the circuit element member 130.

The circuit pattern 120 is coupled and electrically conducted to the LED member 140. The applied voltage and control signal transmitted to the circuit pattern 120 may be transmitted to the LED member 140.

The circuit element member 130 is configured to control the LED member 140 according to the applied voltage and control signal transmitted to the circuit pattern 120. The circuit element member 130 is coupled to the circuit pattern 120. The circuit element member 130 may be provided as a plurality of circuit element members 130 that are electrically conducted to each other. Also, the circuit element member 130 is electrically conducted to the LED member 140.

The circuit element member 130 may be provided in any form that allows the circuit element member 130 to process the received applied voltage and control signal and control the LED member 140 on the basis of the processed applied voltage and control signal. In one embodiment, the circuit element member 130 may be provided as a driving and control element or the like that includes a capacitor, a diode, and an integrated circuit.

The circuit element member 130 may be provided as a plurality of circuit element members 130. The plurality of circuit element members 130 may be electrically conducted to each other and may process the received applied voltage and control signal and control the LED member 140 using the processed applied voltage and control signal. Therefore, it should be understood that the plurality of circuit element members 130 may be defined as a "control unit."

In one embodiment, some of the plurality of circuit element members 130 may be disposed apart from the substrate member 110. In other words, some of the plurality of circuit element members 130 may be disposed outside the substrate member 110.

In this embodiment, some of the plurality of circuit element members 130 may be coupled to a controller (not illustrated) included in the vehicle 1 or may be provided as a separate controller.

The LED member 140 radiates the light L for forming an image in the interior space 30. The light L emitted from the LED member 140 may pass through the inner layer 23 and extend into the interior space 30. In one embodiment, the light L emitted from the LED member 140 may be formed on the inner layer 23 and form an image or may be directly transmitted to the occupant accommodated in the interior space 30.

The LED member 140 may perform dot illumination. Accordingly, the light L emitted from the LED member 140 may also be formed in the shape of a dot. In an embodiment in which the LED member 140 is provided as a plurality of LED members 140, dots formed by rays of light L emitted from the plurality of LED members 140 may be consecutively arranged to form a predetermined image.

The vehicle lighting device 10 according to an embodiment of the present invention includes the optical module 300 which will be described below. The light radiated from the LED member 140 may be refracted while passing through an optic part 330 disposed in the optical module 300 and form images of various forms. Also, the light radiated from the LED member 140 may form an image in the form of a plane by passing through an optical body 310 disposed in the optical module 300.

The LED member 140 is coupled to the formed circuit pattern 120. In the illustrated embodiment, the LED member 140 is coupled to one surface of the substrate member 110 that faces the inner layer 23, that is, the lower surface of the substrate member 110. It should be understood that the one surface of the substrate member 110 is the same as a surface on which the circuit pattern 120 is printed and to which the circuit element member 130 is coupled.

Therefore, the LED member 140 may protrude toward the inner layer 23 past the substrate member 110. Accordingly, the shape of the inner layer 23 may be deformed due to the LED member 140, or the LED member 140 may be damaged due to an external force applied through the inner layer 23. In order to prevent this, the optical module 300 according to an embodiment of the present invention is configured to accommodate the LED member 140.

The LED member 140 and the circuit element member 130 are each coupled and electrically conducted to the circuit pattern 120. An applied voltage and a control signal necessary for the LED member 140 to be operated may be transmitted from the circuit pattern 120 and the circuit element member 130.

The LED member 140 may be provided in any form that allows the LED member 140 to receive the applied voltage and the control signal and be operated accordingly to radiate the light L. In one embodiment, the LED member 140 may be provided as any one or more of an LED, a mini LED, a micro LED, and an LED ink.

The LED member 140 may be configured to radiate the light L of any color. In one embodiment, the LED member 140 may be configured to radiate the light L having a single color, red, green, and blue (RGB), or a combination thereof. Accordingly, an image formed by the LED member 140 may be formed to have one or more colors.

The LED member 140 may be provided as a plurality of LED members 140. The plurality of LED members 140 may be disposed at different positions to separately irradiate the light L.

In the illustrated embodiment, the LED members 140 include a first LED member 141 which is disposed on one surface of the substrate member 110 that faces the inner layer 23, that is, the lower surface of the substrate member 110, and second LED members 142 which are disposed on end surfaces of the optical body 310 in an extending direction thereof, that is, a left side surface and a right side surface of the optical body 310 or an upper side surface and a lower side surface of the optical body 310.

The first LED members 141 and the second LED members 142 may be controlled independently of each other and may each be configured to radiate the light L.

The first LED member 141 is disposed in a space formed between the substrate member 110 and the inner layer 23. The first LED member 141 is disposed between the circuit pattern 120 formed on the substrate member 110 and the inner layer 23.

In the illustrated embodiment, an upper end portion of the first LED member 141 is coupled and electrically conducted to the circuit pattern 120 formed on the substrate member 110. A lower end portion of the first LED member 141 is disposed adjacent to the inner layer 23.

The first LED member 141 may be provided as a plurality of first LED members 141. Any one or more of emission of the light L, and the direction, illumination, luminous intensity, luminance, and color of the emitted light L may be independently controlled for the plurality of first LED members 141.

Accordingly, the light L emitted from the plurality of first LED members 141 may form various images. Further, the light L emitted from the plurality of first LED members 141 may also form an image in the form of motion.

In one embodiment, any one or more of illumination, luminous intensity, and luminance may be higher in the light L radiated from the LED member 140 disposed in a specific region among the plurality of LED members 140, as compared to the light L radiated from the LED member 140 disposed in another region.

That is, the LED member 140 disposed in the specific region may emit the light L that is relatively brighter than the light L emitted from the LED member 140 disposed in another region and may serve as an indoor light, i.e., a room lamp. In this embodiment, since it is not necessary to provide a separate room lamp on the ceiling portion of the vehicle 1, the exterior of the interior space 30 may become more aesthetically pleasing, and efficiency of tasks for manufacturing the vehicle 1 may be improved.

Some of the plurality of first LED members 141 may be configured to radiate the light L toward the optic part 330. That is, the light radiated from some of the first LED members 141 may pass through the optic part 330 and then advance toward the inner layer 23. Accordingly, the light radiated from some of the first LED members 141 may form an image in an optic form.

The rest of the plurality of first LED members 141 may be configured to directly irradiate the light L toward the inner layer 23. That is, the light radiated from the rest of the first LED members 141 may pass through the optical body 310 and advance toward the inner layer 23. Accordingly, the light radiated from the rest of the first LED members 141 may form an image in the form of point luminescence.

The plurality of first LED members 141 may be operated in various forms to form images of various forms in the interior space 30. This will be described in detail below.

The second LED member 142 is disposed on each end surface of the optical body 310 in the extending direction thereof. In other words, the second LED members 142 is disposed on an edge surface of the optical body 310.

The second LED member 142 may be configured to radiate the light L toward the inside of the optical body 310. That is, the light radiated from the second LED member 142 may pass through the optical body 310 and then advance toward the inner layer 23. Accordingly, the light radiated from the second LED member 142 may form an image in the form of plane luminescence.

The transmission module 200 selectively transmits the light L emitted from the light emitting module 100 so that a predetermined image is formed on the inner layer 23 or in the interior space 30.

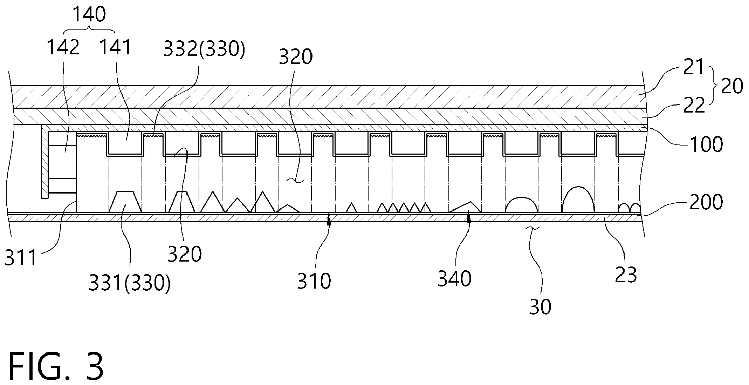

The transmission module 200 is coupled to the inner layer 23. The transmission module 200 is stacked between the inner layer 23 and the light emitting module 100 (specifically, the LED member 140) and is stacked on an upper side of the inner layer 23 in the embodiments illustrated in FIGS. 2 and 3.

The transmission module 200 is disposed between the light emitting module 100 and the optical module 300. That is, in the illustrated embodiment, the transmission module 200, the optical module 300, and the light emitting module 100 are sequentially stacked in that order in a direction from the inside toward the outside. In one embodiment, the transmission module 200 may come into contact with or be coupled to each of the optical module 300 and the inner layer 23. The transmission module 200 may be configured to support the optical module 300.

Therefore, it should be understood that the light L transmitted to the transmission module 200 is the light L that has passed through the optical module 300.

In the illustrated embodiment, the transmission module 200 includes a first portion 210 and a second portion 220.

One portion, i.e., the first portion 210, of the transmission module 200 is formed of a light-permeable material or formed to be penetrated. The light L heading toward the first portion 210 among light L emitted from the light emitting module 100 may pass through the first portion 210 and be radiated toward the inner layer 23 and the interior space 30.

Also, another portion, i.e., the second portion 220, of the transmission module 200 is formed of a non-light permeable material. The light L heading toward the second portion 220 among the light L emitted from the light emitting module 100 is blocked by the second portion 220.

Accordingly, the light L emitted from the light emitting module 100, specifically, the LED member 140, may form an image with a form corresponding to the shapes of the first portion 210 and the second portion 220 of the transmission module 200, on the inner layer 23 or in the interior space 30.

The first portion 210 of the transmission module 200, i.e., a region through which the light L emitted from the LED member 140 passes, may be formed of a character, a figure, a picture, a motion, or a combination thereof.

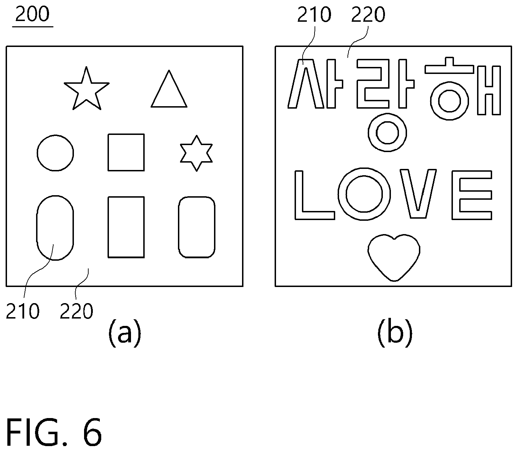

Referring to FIG. 6, examples of images of various forms that are formed by the first portion 210 and the second portion 220 of the transmission module 200 are illustrated.

As illustrated in FIG. 6A, the first portion 210 may be formed of figures of various shapes. Also, as illustrated in FIG. 6B, the first portion 210 may be formed of characters of various shapes.

Consequently, the transmission module 200 may selectively transmit the light L emitted from the light emitting module 100 and form predetermined images of various forms. This will be described in detail below.

Referring to FIGS. 2 and 3, the vehicle lighting device 10 according to an embodiment of the present invention includes the optical module 300.

The light L radiated from the LED member 140 of the light emitting module 100 passes through the optical module 300. Due to the form, properties, or the like of the optical module 300, the light L that has passed through the optical module 300 advances while being refracted in various forms. Accordingly, images of various forms may be formed on the inner layer 23 or in the interior space 30.

The optical module 300 is disposed between the light emitting module 100 and the transmission module 200. In the illustrated embodiment, the optical module 300 is disposed above the transmission module 200 and below the light emitting module 100. In one embodiment, the optical module 300 may be supported by the transmission module 200 and support the light emitting module 100.

In one embodiment, the optical module 300 may be formed to have a size that corresponds to the size of the inner layer 23 and may be provided as a single optical module 300. In another embodiment, the optical module 300 may be formed to have a size that is smaller than the size of the inner layer 23 and may be provided as a plurality of optical modules 300. In this embodiment, the plurality of optical modules 300 may be disposed to correspond to the shapes and arrangement manner of the inner layer 23 and the light emitting module 100 and the transmission module 200 that cover the inner layer 23. That is, in this embodiment, the optical module 300 may be provided to be modular.

In the illustrated embodiment, the optical module 300 includes the optical body 310, an optical hole 320, the optic part 330, and a refractive member 340.

The optical body 310 forms a body of the optical module 300. The optical body 310 is disposed between the light emitting module 100 and the transmission module 200 and disposed on a path along which the light L radiated from the light emitting module 100 is transmitted to advance toward the transmission module 200.

The optical body 310 may extend in a direction identical to the direction in which the substrate member 110 or the transmission module 200 extends. In the illustrated embodiment, the optical body 310 is formed in the shape of a plate whose length in the left-right direction is longer than the length in the front-rear direction and whose thickness is in the up-down direction.

The optical body 310 may be formed of a light-permeable material. Accordingly, the light L radiated from the light emitting module 100 may be transmitted through the optical body 310 and advance toward the optic part 330 or the transmission module 200.

Specifically, the light L radiated from the first LED member 141 may, while advancing in the up-down direction, be transmitted through the optical body 310 and advance toward the transmission module 200. Also, the light L radiated from the second LED member 142 may advance in the horizontal direction or advance with a predetermined slope with respect to the horizontal direction and may be transmitted through the optical body 310 to advance toward the transmission module 200.

Through the optical hole 320 formed therein, the optical body 310 accommodates the LED member 140, the circuit element member 130, or the optic part 330. Here, the optical body 310 may be formed of a soft material or hard material to prevent protrusion of the LED member 140, circuit element member 130, or optic part 330 accommodated therein, i.e., protrusion of the optical body 310 in the thickness direction thereof.

Therefore, it may be said that the optical body 310 also serves to protect the circuit element member 130 or the LED member 140.

The first LED member 141 is disposed on one surface of the optical body 310 that faces the substrate member 110, an upper surface of the optical body 310 in the illustrated embodiment. The second LED members 142 are disposed on end surfaces of the optical body 310 in a longitudinal direction thereof, the left side surface and the right side surface of the optical body 310 in the illustrated embodiment.

The end surfaces on which the second LED members 142 are disposed may be defined as edge surfaces 311. As described above, the edge surfaces 311 form a portion of an outer side surface of the optical body 310.

A second optic part 332 of the optic part 330 may be disposed on a portion of the one surface of the optical body 310, i.e., the upper surface thereof, where the optical hole 320 is not formed. The light L radiated from the first LED member 141 or the second LED member 142 may be refracted while passing through the second optic part 332 and form images of various forms.

The optical hole 320 is formed inside the optical body 310.

The optical hole 320 is formed on one surface of the optical body 310 that faces the substrate member 110, the upper surface of the optical body 310 in the illustrated embodiment. The optical hole 320 may be formed to be recessed in or penetrate through the one surface of the optical body 310. That is, the optical hole 320 may be formed as a groove having a predetermined depth or formed to be penetrated in the thickness direction of the optical body 310.

The optical hole 320 is formed to extend in the thickness direction of the optical body 310, the up-down direction in the illustrated embodiment.

The first LED member 141 or the circuit element member 130 electrically conducted to the first LED member 141 is accommodated in one side of the optical hole 320, which is an upper side of the optical hole 320 in the illustrated embodiment, that faces the substrate member 110 in an extending direction of the optical hole 320. The first LED member 141 may irradiate light toward the transmission module 200 or the inner layer 23 in a state of being accommodated in the optical hole 320.

The optic part 330 is accommodated in the other side of the optical hole 320, which is a lower side of the optical hole 320 in the illustrated embodiment, that faces the transmission module 200 or the inner layer 23 in the extending direction of the optical hole 320. The light L radiated from the first LED member 141 or the second LED member 142 may pass through the optic part 330 and then advance toward the inner layer 23.

The optical hole 320 may be provided as a plurality of optical holes 320. The plurality of optical holes 320 may be disposed apart from each other in an extending direction of the optical body 310. In one embodiment, the plurality of optical holes 320 may be disposed apart from each other in a width direction or breadth direction of the optical body 310.

Here, the plurality of optical holes 320 may be formed to have different shapes. That is, some of the plurality of optical holes 320 may be formed to be recessed while the rest of the plurality of optical holes 320 are formed to be penetrated. Either is fine as long as the optical hole 320 is able to accommodate the first LED member 141 or the circuit element member 130.

The optic part 330 refracts the light L radiated from the LED member 140. The light L that has passed through the optic part 330 is refracted in various forms and extends toward the inner layer 23 so that images of various forms may be formed.

The optic part 330 may be formed of a light-permeable material. Also, the optic part 330 may be formed of any other material and shape that allow the optic part 330 to refract the light L transmitted thereto.

The optic part 330 may be provided as a plurality of optic parts 330. Each of the plurality of optic parts 330 may be disposed at the optical body 310 or the optical hole 320 and may be configured to refract the light L radiated from the first LED member 141 or the second LED member 142.

In the illustrated embodiment, the optic part 330 includes a first optic part 331 accommodated in the optical hole 320 and the second optic part 332 disposed at the optical body 310.

The first optic part 331 is accommodated in the optical hole 320 and configured to refract the light L radiated from the first LED member 141 or the second LED member 142. The first optic part 331 is disposed adjacent to the transmission module 200 or the inner layer 23. In the illustrated embodiment, the first optic part 331 is disposed at a lower portion of the optical hole 320.

The first optic part 331 may be accommodated in a refractive frame 341 and formed as the refractive member 340. That is, as will be described below, the first optic part 331 may be accommodated in the refractive frame 341 to configure the refractive member 340 and then be accommodated in the optical hole 320.

Also, as illustrated in FIG. 3, the first optic part 331 may be directly provided at the other surface of the optical body 310, i.e., the lower surface of the optical body 310, that faces the transmission module 200 or the inner layer 23.

The first optic part 331 may be provided as a plurality of first optic parts 331. The plurality of first optic parts 331 may be formed to have different shapes. Accordingly, light L passing through any one of the plurality of first optic parts 331 may be refracted differently from light L passing through another one of the plurality of first optic parts 331. Consequently, the rays of light L passing through the plurality of first optic parts 331 may form different images.

The plurality of first optic parts 331 may be disposed in various forms. As illustrated in FIG. 3, some of the plurality of first optic parts 331 may be accommodated in the refractive frame 341 and accommodated in the optical hole 320. The rest of the plurality of first optic parts 331 may be directly provided at the other surface of the optical body 310, i.e., the lower surface of the optical body 310.

Some of the plurality of first optic parts 331 may be disposed apart from each other. Also, the rest of the plurality of first optic parts 331 may be consecutively arranged with each other.

The second optic part 332 is disposed at the optical body 310 and configured to refract the light L radiated from the first LED member 141 or the second LED member 142. The second optic part 332 is disposed on a portion of the one surface of the optical body 310, i.e., the upper surface of the optical body 310, where the optical hole 320 is not formed.

The second optic part 332 may be provided as a plurality of second optic parts 332. The plurality of second optic parts 332 may be formed to have different shapes. Accordingly, light L passing through any one of the plurality of second optic parts 332 may be refracted differently from light L passing through another one of the plurality of second optic parts 332. Consequently, the rays of light L passing through the plurality of second optic parts 332 may form different images.

The plurality of second optic parts 332 may be disposed in various forms. As illustrated in FIG. 3, some of the plurality of second optic parts 332 may be consecutively arranged between the optical holes 320 adjacent to each other. As an alternative, the plurality of second optic parts 332 may be disposed apart from each other.

The refractive member 340 is configured to include the first optic part 331 accommodated in the optical hole 320 among the first optic parts 331 and the refractive frame 341 configured to support the first optic part 331 accommodated in the optical hole 320. The refractive member 340 is configured to refract the light L radiated from the first LED member 141 or the second LED member 142.

The refractive member 340 may be provided as a plurality of refractive members 340. The plurality of refractive members 340 may be configured to include one or more first optic parts 331. That is, in the embodiment illustrated in FIG. 2, each refractive member 340 accommodates a single first optic part 331. In the embodiment illustrated in FIG. 3, some of the refractive members 340 accommodate a plurality of first optic parts 331.

The plurality of refractive members 340 are each accommodated in one of the plurality of optical holes 320. The first LED member 141 accommodated in the optical hole 320 is disposed at an outer side of the refractive member 340 accommodated in the optical hole 320, that is, an upper side of the refractive member 340 in the illustrated embodiment.

In the illustrated embodiment, the refractive member 340 includes the refractive frame 341.

The refractive frame 341 has a space formed therein to accommodate the first optic part 331. The refractive frame 341 is formed of a light-permeable material to allow the light L radiated from the first LED member 141 or the second LED member 142 to advance toward the first optic part 331 accommodated therein.

The refractive frame 341 may be formed in a shape that corresponds to the shape of the optical hole 320. In the illustrated embodiment, like the optical hole 320, the refractive frame 341 is formed in the shape of a quadrangular column. Accordingly, arbitrary shaking of the refractive frame 341 inserted into the optical hole 320 and the first optic part 331 accommodated in the refractive frame 341 is prevented, and thus a predetermined image may be stably formed.

The above-described vehicle lighting device 10 according to an embodiment of the present invention may be coupled to the frame 20 of the vehicle 1 and irradiate the interior space 30 with the light L to form images of various forms. Also, the vehicle lighting device 10 may radiate the light L of various forms so that various images are formed in the interior space 30.

Here, a control signal for controlling the light emitting module 100 so that a predetermined image is formed may be generated or changed by a manufacturer of the vehicle 1 or a manufacturer of the vehicle lighting device 10. Alternatively, the control signal may be generated or changed by a user of the vehicle 1 or vehicle lighting device 10.

Also, the light L radiated from the LED member 140 may, after being refracted while passing through the optical module 300, advance toward the inner layer 23 or the interior space 30. Accordingly, the vehicle lighting device 10 according to an embodiment of the present invention may form images of various forms such as point luminescence, plane luminescence, and luminescence due to an optical member.

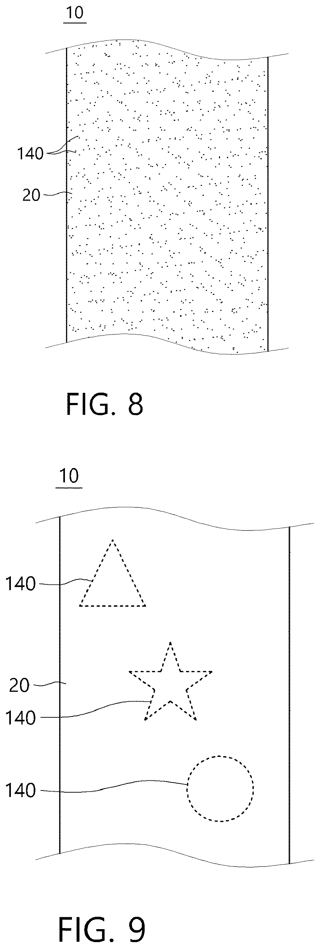

Hereinafter, examples of various images formed by the vehicle lighting device 10 according to an embodiment of the present invention will be described with reference to FIGS. 8 to 12.

Referring to FIG. 8, an embodiment in which an image in the form of a star cluster is formed by the vehicle lighting device 10 according to an embodiment of the present invention is illustrated.

In this embodiment, some of the plurality of LED members 140 are turned on or blink, and the rest of the plurality of LED members 140 are turned off. Here, the LED members 140 that are turned on or blink and the LED members 140 that are turned off may be randomly selected.

Also, color, brightness, saturation, luminous intensity, illumination, luminance, an angle of irradiation, blinking, etc. of light L emitted from the LED members 140 that are turned on or blink may be controlled independently from each other. Accordingly, images formed by the light L emitted from the LED members 140 may also have various forms, and thus the sense of realism may be improved.

Referring to FIG. 9, an embodiment in which images in the form of various figures are formed by the vehicle lighting device 10 according to an embodiment of the present invention is illustrated.

That is, in the illustrated embodiment, a triangular image is formed at the upper left side, a star-shaped image is formed at the center, and a circular image is formed at the lower right side.

In this embodiment, some of the plurality of LED members 140 are turned on, and the rest of the plurality of LED members 140 are turned off. Here, the LED members 140 that are turned on and the LED members 140 that are turned off may be determined based on the figures.

Also, color, brightness, saturation, luminous intensity, illumination, luminance, an angle of irradiation, blinking, etc. of light L emitted from the LED members 140 that are turned on may be controlled independently from each other. Accordingly, images formed by the light L emitted from the LED members 140 may also have various forms, and thus the occupants' satisfaction may be increased.

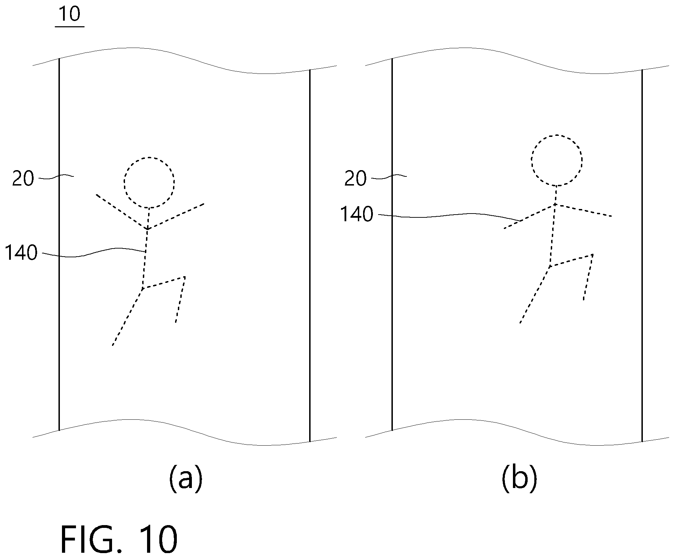

Referring to FIG. 10, an embodiment in which an image in the form of motion is formed by the vehicle lighting device 10 according to an embodiment of the present invention is illustrated.

That is, a human body image formed to be skewed to the left (see FIG. 10A) moves to the right as time passes (see FIG. 10B). Here, the form of the image also changes from a state in which both arms are raised to a state in which both arms are lowered. In this way, an image in the form of motion may be expressed.

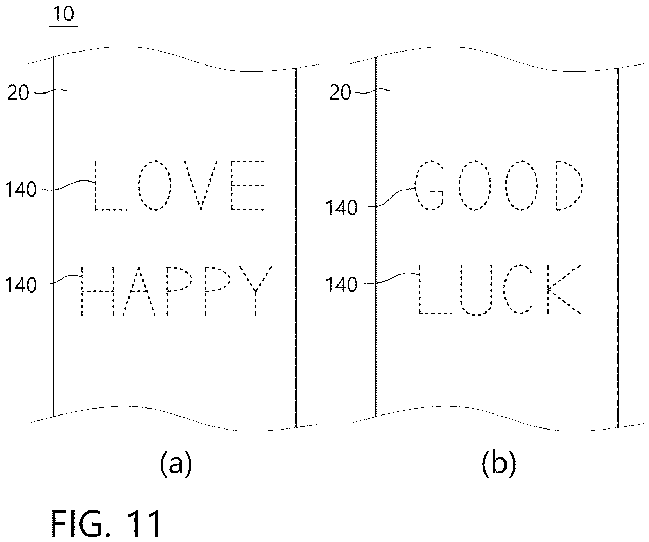

Referring to FIG. 11, another embodiment in which an image in the form of motion is formed by the vehicle lighting device 10 according to an embodiment of the present invention is illustrated.

That is, referring to FIG. 11A, images in the form of characters, such as "LOVE" at an upper side and "HAPPY" at a lower side, are formed on the frame 20 (that is, the inner layer 23). Referring to FIG. 11B, images in the form of different characters, such as "GOOD" at the upper side and "LUCK" at the lower side, are formed on the frame 20 as time passes.

Even in this embodiment, as in the embodiment illustrated in FIG. 10, some of the plurality of LED members 140 are turned on, and the rest of the plurality of LED members 140 are turned off. Here, the LED members 140 that are turned on and the LED members 140 that are turned off may be determined based on predetermined images to be expressed.

Here, as time passes, the LED members 140 that are turned on and the LED members 140 that are turned off among the plurality of LED members 140 may be changed. Consequently, images formed by the light L emitted from the plurality of LED members 140 may be changed over time.

Accordingly, since the form of images formed on the inner layer 23 or in the interior space 30 changes over time, the occupant's boredom may be reduced even when the vehicle 1 is driven for a long time.

In the illustrated embodiments, cases where images are changed over time from figure to figure or character to character are illustrated. As an alternative, an image in the form of any one of the above-described characters, figures, and pictures may be changed to an image in the form of any one or more of characters, figures, and pictures to form an image in the form of motion.

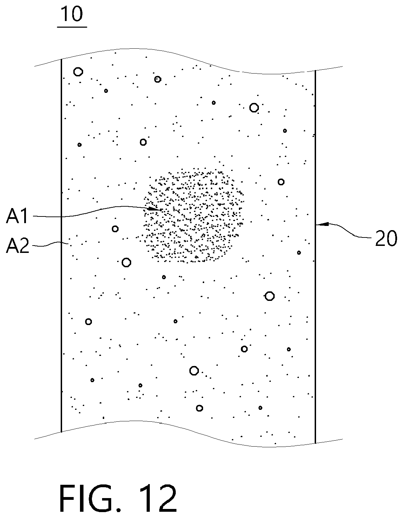

Referring to FIG. 12, an example in which an image in the form of nebulae is formed by the vehicle lighting device 10 according to an embodiment of the present invention is illustrated.

Here, the inner layer 23 on which the image is formed may be divided into a first region A1 and a second region A2.

In the first region A1, images are formed by the light L that is radiated from the first LED member 141 or the second LED member 142 and transmitted through the optical body 310 and the transmission module 200. That is, the images formed in the first region A1 may be defined as images in the form of plane luminescence.

In the second region A2, images are formed by the light L that is radiated from the first LED member 141 or the second LED member 142 and transmitted through the transmission module 200 or the optic part 330.

Among the images formed in the second region A2, an image formed by the light L that has passed through only the transmission module 200 may be defined as an image in the form of point luminescence. Also, among the images formed in the second region A2, an image formed by the light L that has been transmitted through the optic part 330 may be defined as luminescence due to the optical member.

Here, it should be understood that the images formed in the first region A1 may also be formed by the light L passing through the optic part 330.

Also, the brightness, shape, position, etc. may be formed to be different for the images formed in the form of plane luminescence, point luminescence, or luminescence due to the optical member.

Therefore, the vehicle lighting device 10 according to an embodiment of the present invention may form an image in the form of plane luminescence in a portion of the inner layer 23 or the interior space 30, may form an image in the form of point luminescence in another portion thereof, and may form an image in the form of luminescence due to the optical member in still another portion thereof.

Accordingly, various images may be formed on the inner layer 23 or in the interior space 30 by luminescence in various forms, and thus comfort and satisfaction of a user may be improved.

According to the configurations described above, a vehicle lighting device and a vehicle including the same according to an embodiment of the present invention allow effective application of the vehicle lighting device according to the shape of the vehicle.

Also, according to the configurations described above, the vehicle lighting device and vehicle including the same according to an embodiment of the present invention allow images of various forms to be effectively formed.

Also, according to the configurations described above, the vehicle lighting device and vehicle including the same according to an embodiment of the present invention allow images of various forms to be formed in a space inside the vehicle.

Also, according to the configurations described above, the vehicle lighting device and vehicle including the same according to an embodiment of the present invention allow prevention of damage to a component for emitting light.

In addition, according to the configurations described above, the vehicle lighting device and vehicle including the same according to an embodiment of the present invention allow an exterior to be aesthetically pleasing.

Advantageous effects of the present invention are not limited to those mentioned above and should be understood as including any effect deducible from the detailed description of the present invention or configurations of the invention described in the appended claims.

Embodiments of the present invention have been described above, but the spirit of the present invention is not limited by the embodiments proposed herein. Those of ordinary skill in the art who understand the spirit of the present invention may easily propose other embodiments by addition, modification, omission, or the like of components within the scope of the same spirit, but such embodiments also belong to the scope of the spirit of the present invention.

In particular, the invention relates to the following preferred embodiments:
Embodiment 1. A vehicle lighting device irradiating an interior space of a vehicle with light, the vehicle lighting device comprising:
   a light emitting module configured to irradiate the interior space with light transmitted through an inner layer surrounding the interior space;
   an optical module disposed between the light emitting module and the inner layer so that the light radiated from the light emitting module is transmitted therethrough; and
   a transmission module which is disposed between the optical module and the inner layer and includes one portion through which the light emitted from the light emitting module is transmitted and another portion configured to block the emitted light,
   wherein the light emitting module includes a light emitting diode (LED) member electrically conducted to the outside to emit the light according to a control signal and an applied voltage transmitted thereto,
   the optical module includes an optical body which is formed of a light-permeable material and disposed to cover the inner layer and an optical hole which is formed to be recessed in or penetrate through the inside of the optical body to form a space in a thickness direction thereof, and
   the LED member includes a first LED member which is accommodated in the optical hole and configured to irradiate the inner layer with light and a second LED member which is disposed on an edge surface of the optical body and configured to irradiate the inner layer with light transmitted through the inside of the optical body.
Embodiment 2. The vehicle lighting device of embodiment 1, wherein:
   a portion of the light emitted from the LED member is transmitted due to the one portion of the transmission module; and
   another portion of the light emitted from the LED member is blocked by the other portion of the transmission module, thus creating a mood lighting atmosphere.
Embodiment 3. The vehicle lighting device of embodiment 1, wherein, in a thickness direction of the optical module, the optical hole accommodates the first LED member or a circuit element member electrically conducted to the first LED member.
Embodiment 4. The vehicle lighting device of embodiment 3, wherein the circuit element member is provided as a plurality of circuit element members, and the plurality of circuit element members are configured to control the LED member according to the applied voltage and the control signal transmitted thereto.
Embodiment 5. The vehicle lighting device of embodiment 1, wherein the optical hole is provided as a plurality of optical holes, and the plurality of optical holes are disposed apart from each other in a width direction of the optical body.
Embodiment 6. The vehicle lighting device of embodiment 1, wherein the second LED member is provided as a plurality of second LED members, and the plurality of second LED members are each disposed on one edge surface of the optical body.
Embodiment 7. The vehicle lighting device of embodiment 1, wherein the optical module includes a refractive member which is inserted into the optical hole and includes an optic part configured to refract the light radiated from the first LED member accommodated in the optical hole.
Embodiment 8. The vehicle lighting device of embodiment 7, wherein the optical body is formed of a soft material or a hard material to accommodate any one or more of the LED member, the circuit element member electrically conducted to the LED member, and the optic part and prevent protrusion thereof in the thickness direction.
Embodiment 9. The vehicle lighting device of embodiment 1, wherein an optic part configured to refract the light radiated from the first LED member accommodated in the optical hole is formed at one side surface of the optical body that faces the inner layer.
Embodiment 10. The vehicle lighting device of embodiment 7 or 9, wherein the optic part is provided as a plurality of optic parts, and the plurality of optic parts are formed to have different shapes.
Embodiment 11. The vehicle lighting device of embodiment 7 or 9, wherein the optic part is provided as a plurality of optic parts, and the plurality of optic parts are disposed to correspond to the optical hole which is provided as a single optical hole or a plurality of optical holes.
Embodiment 12. The vehicle lighting device of embodiment 1, wherein the light emitting module is modularized and provided as a plurality of light emitting modules, and the plurality of light emitting modules are disposed to correspond to the shape of the inner layer.
Embodiment 13. The vehicle lighting device of embodiment 1, wherein the optical module is modularized and provided as a plurality of optical modules, and the plurality of optical modules are disposed to correspond to the plurality of light emitting modules.
Embodiment 14. The vehicle lighting device of embodiment 1, wherein:
   the first LED member and the second LED member are provided as any one or more of an LED, a mini LED, a micro LED, and an LED ink; and
   the light radiated from the first LED member or the second LED member has a single color, red, green, and blue (RGB), or a combination thereof.
Embodiment 15. The vehicle lighting device of embodiment 14, wherein rays of light radiated from the first LED member and the second LED member at least partially overlap on the inner layer or in the interior space to form a predetermined image.
Embodiment 16. The vehicle lighting device of embodiment 14, wherein rays of light independently radiated from the second LED member at least partially overlap on the inner layer or in the interior space to form a predetermined image.
Embodiment 17. The vehicle lighting device of embodiment 1, wherein:
   the LED member is provided as a plurality of LED members, and the plurality of LED members are disposed in different regions;
   any one or more of emission of light, and the direction, luminous intensity, illumination, luminance, and color of the emitted light are independently controlled for the plurality of LED members; and
   the light emitted from the plurality of LED members forms an image of a character, a figure, a picture, a motion, or a combination thereof.
Embodiment 18. The vehicle lighting device of embodiment 17, wherein:
   the optical module includes a plurality of optic parts configured to refract the light radiated from the plurality of LED members each inserted into one of the plurality of optical holes; and
   the plurality of optic parts are formed to have different shapes so that the light radiated from the plurality of LED members transmit through the plurality of optic parts and from images of different shapes.
Embodiment 19. The vehicle lighting device of embodiment 1, wherein the light emitted from the LED member sequentially passes through the one portion of the transmission module and the inner layer to form a predetermined image in the interior space.
Embodiment 20. The vehicle lighting device of embodiment 1, wherein the one portion of the transmission module is formed of a character, a figure, a picture, a motion, or a combination thereof.
Embodiment 21. A vehicle comprising:
   an inner layer surrounding an interior space; and
   a vehicle lighting device stacked on the inner layer to irradiate the interior space with light,
   wherein the vehicle lighting device includes a light emitting module which is configured to irradiate the interior space with light transmitted through the inner layer and an optical module which is disposed between the light emitting module and the inner layer so that the light radiated from the light emitting module is transmitted therethrough,
   the light emitting module includes a first LED member which is configured to irradiate the inner layer with light vertical thereto and a second LED member which is configured to irradiate the inner layer with light horizontal thereto,
   the optical module includes an optical body which is formed of a light-permeable material and disposed to cover the inner layer and a plurality of optical holes which are formed to penetrate or not penetrate through the inside the optical body in a thickness direction thereof,
   the first LED member is accommodated in the optical hole and configured to irradiate the inner layer with light, and
   the second LED member is disposed on an edge surface of the optical body and configured to irradiate the inner layer with light transmitted through the inside of the optical body.
Embodiment 22. The vehicle of embodiment 21, wherein:
   the optical module includes a plurality of optic parts accommodated in the plurality of optical holes and configured to refract the light radiated from the LED member; and
   any one or more of the plurality of optic parts are formed to have a shape different from that of one or more other optic parts.
Embodiment 23. The vehicle of embodiment 21, further comprising a transmission module which is disposed between the optical module and the inner layer and includes one portion through which the light emitted from the LED member is transmitted and another portion configured to block the emitted light.
Embodiment 24. The vehicle of embodiment 21, wherein:
   the first LED member is provided as a plurality of first LED members, and the plurality of first LED members are each accommodated in one of the plurality of optical holes; and
   the second LED member is provided as a plurality of second LED members, and the plurality of second LED members are each disposed on one edge surface of the optical body.
Embodiment 25. The vehicle of embodiment 21, wherein the light irradiated by the first LED member and the light irradiated by the second LED member at least partially overlap on the inner layer or in the interior space to form a predetermined image.

## Claims

1. A vehicle lighting device (10) irradiating an interior space (30) of a vehicle (1) with light, the vehicle lighting device (10) comprising:
a light emitting module (100) configured to irradiate the interior space (30) with light transmitted through an inner layer (23) surrounding the interior space (30);
an optical module (300) disposed between the light emitting module (100) and the inner layer (23) so that the light radiated from the light emitting module (100) is transmitted therethrough; and
a transmission module (200) which is disposed between the optical module (300) and the inner layer (23) and includes one portion through which the light emitted from the light emitting module (100) is transmitted and another portion configured to block the emitted light,
wherein the light emitting module (100) includes a light emitting diode (LED) member (140) electrically conducted to the outside to emit the light according to a control signal and an applied voltage transmitted thereto,
the optical module (300) includes an optical body (310) which is formed of a light-permeable material and disposed to cover the inner layer (23) and an optical hole (320) which is formed to be recessed in or penetrate through the inside of the optical body (310) to form a space in a thickness direction thereof, and
the LED member (140) (140) includes a first LED member (141) which is accommodated in the optical hole (320) and configured to irradiate the inner layer (23) with light and a second LED member (142) which is disposed on an edge surface (311) of the optical body (310) and configured to irradiate the inner layer (23) with light transmitted through the inside of the optical body (310).

2. The vehicle lighting device (10) of claim 1, wherein:
a portion of the light emitted from the LED member (140) is transmitted due to the one portion of the transmission module (200); and
another portion of the light emitted from the LED member (140) is blocked by the other portion of the transmission module (200), thus creating a mood lighting atmosphere.

3. The vehicle lighting device (10) of claim 1, wherein, in a thickness direction of the optical module (300), the optical hole (320) accommodates the first LED member (141) or a circuit element member (130) electrically conducted to the first LED member (141), and
wherein the circuit element member (130) is provided as a plurality of circuit element members (130), and the plurality of circuit element members (130) are configured to control the LED member (140) according to the applied voltage and the control signal transmitted thereto.

4. The vehicle lighting device (10) of claim 1, wherein the optical hole (320) is provided as a plurality of optical holes (320), and the plurality of optical holes (320) are disposed apart from each other in a width direction of the optical body (310).

5. The vehicle lighting device (10) of claim 1, wherein the second LED member (142) is provided as a plurality of second LED members (142), and the plurality of second LED members (142) are each disposed on one edge surface (311) of the optical body (310).

6. The vehicle lighting device (10) of claim 1, wherein the optical module (300) includes a refractive member (340) which is inserted into the optical hole (320) and includes an optic part (330) configured to refract the light radiated from the first LED member (141) accommodated in the optical hole (320), and
wherein the optical body (310) is formed of a soft material or a hard material to accommodate any one or more of the LED member (140), the circuit element member (130) electrically conducted to the LED member (140), and the optic part (330) and prevent protrusion thereof in the thickness direction.

7. The vehicle lighting device (10) of claim 1, wherein an optic part (330) configured to refract the light radiated from the first LED member (141) accommodated in the optical hole (320) is formed at one side surface of the optical body (310) that faces the inner layer (23).

8. The vehicle lighting device (10) of claim 6 or 7, wherein the optic part (330) is provided as a plurality of optic parts (330), and the plurality of optic parts (330) are formed to have different shapes.

9. The vehicle lighting device (10) of claim 6 or 7, wherein the optic part (330) is provided as a plurality of optic parts (330), and the plurality of optic parts (330) are disposed to correspond to the optical hole (320) which is provided as a single optical hole (320) or a plurality of optical holes (320).

10. The vehicle lighting device (10) of claim 1, wherein the light emitting module (100) is modularized and provided as a plurality of light emitting modules (100), and the plurality of light emitting modules (100) are disposed to correspond to the shape of the inner layer (23).

11. The vehicle lighting device (10) of claim 1, wherein the optical module (300) is modularized and provided as a plurality of optical modules (300), and the plurality of optical modules (300) are disposed to correspond to the plurality of light emitting modules (100).

12. The vehicle lighting device (10) of claim 1, wherein:
the first LED member (141) and the second LED member (142) are provided as any one or more of an LED, a mini LED, a micro LED, and an LED ink; and
the light radiated from the first LED member (141) or the second LED member (142) has a single color, red, green, and blue (RGB), or a combination thereof, and
wherein rays of light radiated from the first LED member (141) and the second LED member (142) at least partially overlap on the inner layer (23) or in the interior space (30) to form a predetermined image.

13. The vehicle lighting device (10) of claim 1, wherein:
the LED member (140) is provided as a plurality of LED members (140), and the plurality of LED members (140) are disposed in different regions;
any one or more of emission of light, and the direction, luminous intensity, illumination, luminance, and color of the emitted light are independently controlled for the plurality of LED members (140); and
the light emitted from the plurality of LED members (140) forms an image of a character, a figure, a picture, a motion, or a combination thereof, and
wherein:
the optical module (300) includes a plurality of optic parts (330) configured to refract the light radiated from the plurality of LED members (140) each inserted into one of the plurality of optical holes (320); and
the plurality of optic parts (330) are formed to have different shapes so that the light radiated from the plurality of LED members (140) transmit through the plurality of optic parts (330) and from images of different shapes.

14. The vehicle lighting device (10) of claim 1, wherein the light emitted from the LED member (140) sequentially passes through the one portion of the transmission module (200) and the inner layer (23) to form a predetermined image in the interior space (30).

15. The vehicle lighting device (10) of claim 1, wherein the one portion of the transmission module (200) is formed of a character, a figure, a picture, a motion, or a combination thereof.
